**Europäisches Patentamt**

(19) **European Patent Office**

**Office européen des brevets**

(11) Publication number: **0 044 138**
**B1**

(12) **EUROPEAN PATENT SPECIFICATION**

(45) Date of publication of patent specification: **06.05.87**

(21) Application number: **81302626.7**

(22) Date of filing: **12.06.81**

(51) Int. Cl.⁴: **H 05 K 3/44**

(54) **Electrical circuit on porcelain coated metal substrate.**

(30) Priority: **10.07.80 CA 355876**

(43) Date of publication of application:
**20.01.82 Bulletin 82/03**

(45) Publication of the grant of the patent:
**06.05.87 Bulletin 87/19**

(84) Designated Contracting States:
**AT BE CH DE FR GB LI NL SE**

(56) References cited:
**EP-A-0 006 810**
**FR-A-1 584 094**
**FR-A-2 305 913**
**GB-A- 939 394**
**US-A-4 074 419**
**US-A-4 188 652**

**RCA REVIEW, vol.42, no.2, June 1981,
PRINCETON, N.J. (US), D.P. DORSEY et al.:
"The design, construction, and evaluation of a
porcelainized-steel-substrate hybrid-circuit
module"**

(73) Proprietor: **NORTHERN TELECOM LIMITED
1600 Dorchester Boulevard West
Montreal Quebec H3H 1R1 (CA)**

(72) Inventor: **Chaput, Guy John
R.R. Nos. 2
Carlton Place Ontario K7C 3P2 (CA)**
Inventor: **Sich, Edward Matthew
1300 Pinecrest Road Apt. 1514
Ottawa Ontario K2C 3M5 (CA)**

(74) Representative: **Crawford, Andrew Birkby et al
A.A. THORNTON & CO. Northumberland House
303-306 High Holborn
London WC1V 7LE (GB)**

EP 0 044 138 B1

## Description

This invention relates to electrical circuits on porcelain coated metal substrates.

Suggestions are being put forward for the replacement of conventional printed circuit boards with circuits printed upon porcelain coats formed upon metal substrates such as steel. The attractiveness of replacing conventional printed circuit boards is mainly economic in that the resin/glass fibre substrate, copper coating, etching, nickel plating and gold plating techniques are avoided. The new suggested process involves much cheaper production techniques in providing the porcelain coat upon the steel substrate and forming the circuit by thick film printing techniques. See for example "McGraw-Hill Encyclopedia of Science and Technology", Vol. 10, 1977 — L.K. Lee, p. 682—692, in particular p. 685, column 2.

Although a cheaper product thus results, proprietary electrical filters formed from proprietary components are still required in the circuit to eliminate undesirable frequencies which, for instance, result in sound distortion or interference in use of audio equipment such as microphones or telecommunications equipment. Such frequencies result from undesired capacitive effects between the substrate and the printed circuit. Such effects are known, see for example French Patent Specification FR—A—2305913.

The present invention is concerned with the provision of a circuit board comprising a porcelain coated metal substrate bearing a printed electrical circuit in which undesirable frequencies may be eliminated without the use of conventional filters by close control over inherent capacitive effects.

The present invention provides in a printed circuit board (34) comprising a circuit (36) printed on a porcelain layer (35) carried on an electrically conductive substrate, a method of controlling capacitive effects which occur between the substrate and the circuit, the method being characterized by the steps of:

forming an area of predetermined size of an electrically conductive material on the porcelain layer additional to the printed circuit; and

providing means for connecting said area to ground, the arrangement being such that there is provided, in series with the capacitance existing between the printed circuit and the substrate, a capacitance between said area and the substrate whose value is predetermined by the size of said area and the thickness of the porcelain layer.

Circuit boards according to the invention are of particular use in audio equipment where radio and other high frequencies may be eliminated so as not to interfere with the desired audio frequencies.

Hence the invention also includes pushbutton switch assembly for telecommunications apparatus as claimed in claim 3.

A pushbutton switch assembly for telecommunications apparatus according to the invention comprises pushbutton means and a switch contact circuit associated with the pushbutton means so as to have contact areas connected by operation of the pushbutton means, and a circuit board according to the invention defined above, the printed circuit being connected to the switch contact circuit to transmit an audio signal to a desired destination upon connection of said contact areas.

An embodiment of the invention will now be described by way of example with reference to the accompanying drawings in which:—

Figure 1 is a plan view of a circuit board included for the purposes of explanation;

Figure 2 is a cross-sectional view of the board of Figure 1 taken along line II—II in Figure 1 and showing the material thickness not to scale;

Figure 3 is a view similar to Figure 1 showing alternative printed circuit designs in modifications of the circuit board of Figure 1;

Figure 4 is a plan view of a further circuit board;

Figure 5 is a cross-sectional view taken along line V—V in Figure 4;

Figure 6 is a plan view of a circuit board according to an embodiment of the invention;

Figure 7 is an exploded isometric view of a pushbutton assembly for a telephone dial incorporating a circuit board;

Figure 8 is an underside plan view of the circuit board incorporated in the assembly of Figure 6.

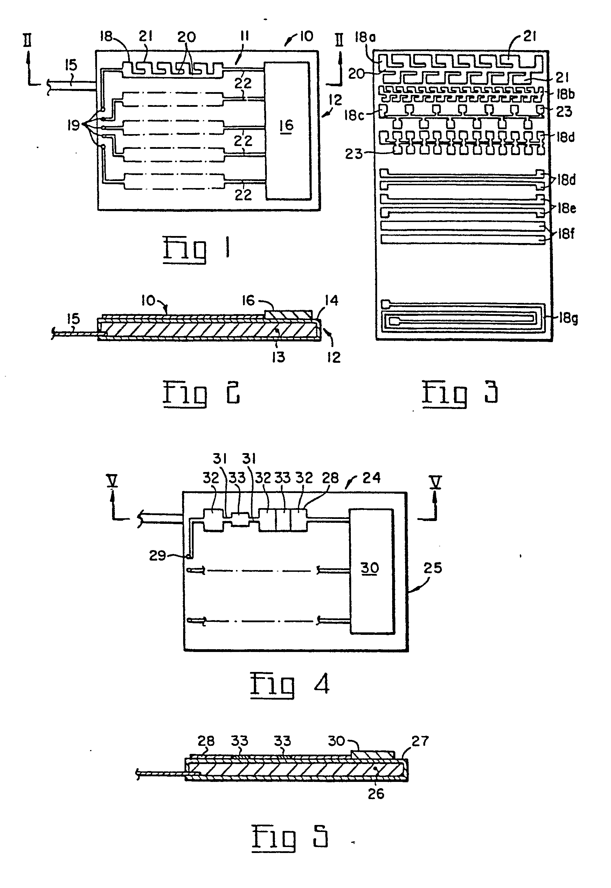

In a first circuit board as shown in Figures 1 and 2, a circuit board 10 comprises a circuit 11 printed upon a planar support 12.

The support 12 is formed by a metal, i.e. steel sheet 13 substrate coated on at least its upper surface with a layer of porcelain 14. A particular way of forming the porcelain layer is by electrodeposition of a frit on the steel sheet, followed by firing. Conveniently it may be easier during forming the layer, to coat the whole steel sheet in frit so as to have it covered by porcelain on both surfaces as shown by Figure 2.

It is a desirable feature that the steel sheet has a means by which it is connectable to ground. As shown in Figures 1 and 2, a ground lead 15 is soldered or otherwise electrically attached to the steel sheet and extends outwardly from the porcelain for making a ground connection. Clearly, attachment of the ground lead is made before covering the steel sheet with frit and firing it.

The circuit board also comprises upon its upper surface, an integrated circuit device 16 attached to the porcelain layer. This device is located in a position spaced from ground lead 15 and, in fact, lies in an extreme position on the support 12 from the lead.

The printed circuit 11 is formed, for instance, by thick film techniques. In one such technique, the circuit pattern is formed from an ink containing silver and glass particles, the ink being fired at, say 600°C, to transform the ink into a hard coating which is held together and to the porcelain by the glass particles. Instead of silver, paladium or platinum particles may be used, for instance.

Because of the ground lead 15, a capacitance created from the printed circuit pattern to the steel sheet. The value of this effect depends upon the electrical characteristics of the porcelain, but may be determined to give a desired value by providing the porcelain with a desired thickness and presenting a predetermined surface area of contact between the printed circuit and the porcelain. Hence, the value of the capacitance and resistor effect is built into the circuit board to remove whatever frequencies are required to be filtered from the circuit and before current reaches the integrated circuit 16. The desired area of contact between each conductor 18 and the porcelain is producible by forming the conductor in a certain shape between its input terminal 19 and the integrated circuit. As shown in Figure 1, in one example, each conductor 18 has narrow section portions 20 for determining the resistance, and larger spaced regions 21 projecting from one side of the conductor and joined by sections 20. Obviously while the regions 21 have no effect upon the electrical resistance characteristics from the input end up to the circuit 16, their size dictates the area of contact between the conductor and the porcelain.

It will be noted that the integrated circuit 16 is disposed at the end of the support 12 remote from the ground lead 15. This minimizes any interference effect upon the circuit 16 by the use of the steel plate as part of the capacitor. The steel is slightly inductive and thus assists in preventing or minimizing interference in this way. Further, the integrated circuit is isolated as far as possible from the printed circuit to minimize interference by providing conductor regions 22 to the integrated circuit with as small a cross-sectional area as is practicable when taking into account the current which has to flow to the integrated circuit.

In use, thickness of the upper porcelain layer and the area of contact between each conductor 18 with the porcelain dictates the lossy capacitance effects and these may be predetermined to eliminate or minimize undesirable frequencies reaching the integrated circuit 16.

Figure 3 shows various modifications to the shape of the printed circuit in Figure 1. Each of these shapes is chosen to provide a certain contact area between a conductor and the porcelain to give a required lossy capacitance effect.

For instance, as shown, in one modification conductor 18a has larger spaced regions 21 at each side of narrow section 20. In another modification, a conductor 18b has the same pattern as conductor 18a but has a smaller scale dictated by its requirements. In conductors 18c and 18d, the larger regions 23 are of different shape, with 18d producing a greater contact surface area with the porcelain by using more regions 23.

In the designs of conductors, 18d, 18e and 18f, the required contact area is obtained by providing each conductor with parallel sides and with no enlarged regions. Conductor 18g provides the required contact area by causing it to pass backwards and forwards across the support between its terminals.

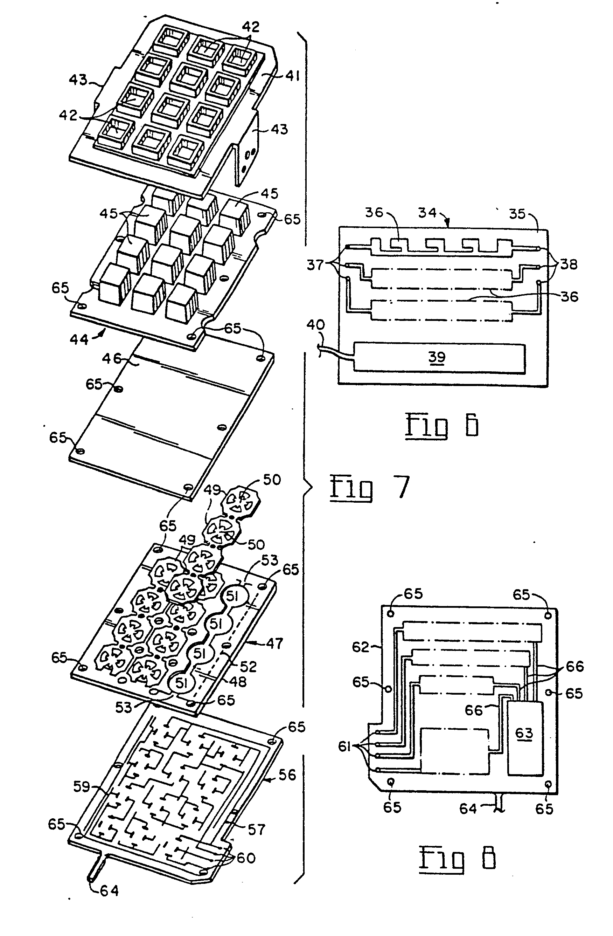

As shown in Figures 4 and 5, in a second circuit board, a circuit board 24 has a support 25 of metal substrate 26 and porcelain 27 construction as described in Figure 1. Each conductor 28 extending from inlet terminal 29 to integrated circuit 30 has narrow sections 31 and larger regions 32 to provide the resistance effects of the conductor and the lossy capacitance effects in conjunction with the substrate 26. Each conductor also has a plurality of resistors 33 located along its length, the resistors having been added by thick film printing using printing inks with suitable electrical properties. In this construction, the resistors 33 also provide a lossy capacitance effect in conjunction with the metal substrate over the whole contact surface area of the resistors with the porcelain. The resistances of resistors 33 may be changed by using printing inks with different ohms/square materials.

In a circuit board according to an embodiment of the invention (Figure 6), a circuit board 34 is provided. This board has a support of metal substrate (not shown) covered overall in a porcelain layer 35. A printed circuit on an upper circuit on an upper surface of the layer 35 comprises conductors 36 in parallel, each extending between inlet and outlet terminals 37, 38 at opposite ends of the support. Each conductor is shaped to give a desired area of contact with the porcelain as described above. In this embodiment, no integrated circuit is carried by the board. Instead, an integrated circuit (not shown) is carried by a second board (not shown) and is joined to the outlet terminals 38. The use of the second board ensures that the integrated circuit is completely isolated from the metal substrate of board 34 and cannot pick up any interference from the board.

In this embodiment, the lossy capacitance effect from the printed circuit to the metal substrate is not provided by equipping the metal substrate with a ground connection. Instead, an additional conductor plate 39 is thick film printed, in the manner of the printed circuit, on the upper surface of the porcelain as shown. Alternatively, the plate 39 is printed upon the lower surface. The plate 39 is provided with its own ground connection 40.

In use, two capacitance effects are created in series to give the desired frequency elimination effects. The first of these is between each of the conductors 36 and the metal substrate and the second between the substrate and the plate 39.

In a further arrangement, a circuit board according to the invention may be incorporated into a pushbutton switch assembly of a telecommunications apparatus. In this arrangement as shown by Figure 7, the pushbutton assembly comprises a moulded plastic bezel 41 with apertures 42 in rows. Brackets 43 moulded integrally with the bezel at its sides provide mounting means for the assembly to a chassis (not shown).

On the underside of the bezel is a moulded button or key plate 44 which contacts the bezel, and has integrally moulded keys or buttons 45 extending, one through each aperture 42 in the bezel. The keys are joined to the plate at one side of each key only, so that a resilient hinging effect is created which enables the keys to be manually depressed through the apertures.

Beneath the plate 44 is a thin resiliently flexible membrane 46 and then a spring contact assembly 47. The spring contact assembly 47 comprises a support member 48 for three strips 49 each comprising four spring contact members 50. The member 48 has a plurality of apertures 51 corresponding in position to the apertures 42 in the bezel. Each strip 49 is located in a desired position on the support member by its reception within a shallow recess 52 in the support member, and ends of the strips fit in slits cut in a key member 53 at each end of the support member.

The spring contact members 50 are held in position over the apertures 51, one to each aperture, by positioning of the strips 49. Each contact member is conveniently in the form described in U.S. patent 4,029,916, having a snap action when the centre portion of a contact member is depressed by depression of a key 45 directly above it. When a contact member snaps down through its aperture 51, contacts 50 move into engagement with a contact area 54 of a circuit board 56.

The circuit board 56 comprises a support member 57 formed from a steel sheet substrate (not shown) and bearing a porcelain covering layer 58 on all surfaces. The support member is manufactured in the manner described in Figure 1. On the upper surface of the porcelain is a switch contact circuit 59 which has a contact area 54 disposed below each of the apertures 51.

The contact circuit 59 has outlet terminals 60 which are electrically connected by means of strip conductors (not shown) with inlet terminals 61 of a printed circuit 62 on the under surface of the porcelain (Figure 8), the circuit 62 being connected to an integrated circuit 63 at one end of the support member. The circuits 59 and 62 are both printed by thick film techniques in the manner described above. The steel sheet of the support member has a ground connection 64 extending from it for grounding purposes. The support member has six spaced holes 65 for alignment with corresponding holes 65 in the membrane 46, plate 44 and support member 48 when the elements are assembled together by passage of studs (not shown) moulded on the undersurface of the bezel 41. The holes 55 in the support member are formed by drilling them in the steel sheet before the porcelain layer is added, care being taken to cover the metal within the holes with porcelain while leaving the holes; unblocked and free for passage of the studs. This ensures that the only ground connection is by way of item 64.

The circuit board 56 is designed to eliminate or minimize radio and other high frequency signals from reaching the integrated circuit which may, for instance, be an amplifier. The design of the printed circuit taken in conjunction with the thickness of the porcelain layer and its electrical properties is such as to effect high frequency decoupling while allowing audio frequencies to pass to the integrated circuit. The use of steel as the substrate effectively increases the radio frequency decoupling. A high capacitance to ground should be avoided as this may affect audio frequency reception at the integrated circuit. For this purpose, the final conductors 66 to the integrated circuit are designed as narrow as possible.

In the last preceding embodiment, a single element, i.e. the board 56 operates to carry the switch contact circuit 59, the printed circuit 62 which eliminates unwanted frequencies from the signal, and the integrated circuit which may include the amplifier. While providing all these various elements in a small package, costly proprietary filter items are avoided and replaced relatively cheaply by incorporating filtering means into the board itself by way of forming the capacitor and resistor effect between the printed circuit and the steel substrate.

In a modification of the last embodiment, the integrated circuit is included upon a mounting which is separate from the circuit board 56.

## Claims

1. In a printed circuit board (34) comprising a circuit (36) printed on a porcelain layer (35) carried on an electrically conductive substrate, a method of controlling capacitive effects which occur between the substrate and the circuit, the method being characterized by the steps of:

forming an area (39) of predetermined size of an electrically conductive material on the porcelain layer additional to the printed circuit; and

providing means (40) for connecting said area to ground, the arrangement being such that there is provided, in series with the capacitance existing between the printed circuit and the substrate, a capacitance between said area and the substrate whose value is predetermined by the size of said area and the thickness of the porcelain layer.

2. A printed circuit board when produced by the method according to claim 1.

3. A pushbutton switch assembly for telecommunications apparatus comprising pushbutton means and a switch contact circuit associated with the pushbutton means so as to have contact areas connected by operation of the pushbutton means, characterized in that it includes a circuit board (56) according to claim 2, the printed circuit (62) being connected to the switch contact circuit (59) to transmit an audio signal to a desired destination upon connection of said contact areas.

## Patentansprüche

1. Bei einer gedruckten Schaltplatine (34) mit einer auf eine Porzellanschicht (35) an einem elektrisch leitenden Substrat aufgedruckten Schaltung (36), ein Verfahren zum Steuern kapazitiver Effekte, die zwischen dem Substrat und der Schaltung auftreten, wobei das Verfahren durch die folgenden Schritte gekennzeichnet ist:

Ausbilden einer Fläche (39) vorbestimmter Größe aus einem elektrisch leitenden Material an der Porzellanschicht zusätzlich zu der gedruckten Schaltung, und Schaffen von Mitteln (40) zum Verbinden der Fläche mit Masse, wobei die Anordnung so getroffen ist, daß in Reihe mit der zwischen der gedruckten Schaltung und dem Substrat bestehenden Kapazität eine Kapazität zwischen der Fläche und dem Substrat geschaffen wird, deren Wert durch die Größe der Fläche und die Dicke der Porzellanschicht vorbestimmt ist.

2. Gedruckte Schaltplatine, durch das Verfahren nach Anspruch 1 hergestellt.

3. Druckknopf-Schaltanordnung für Nachrichtenverbindungsgerät mit Druckknopfmittel und einem dem Druckknopfmittel zugeordneten Schaltkontaktkreis, bei dem durch Betätigung des Druckknopfmittels verbundene Kontaktflächen vorhanden sind, dadurch gekennzeichnet, daß eine Schaltplatine (56) nach Anspruch 2 enthalten ist, wobei die gedruckte Schaltung (62) so mit dem Schaltkontaktkreis (59) verbunden ist, daß ein Audiosignal zu einer erforderlichen Bestimmungsstelle nach Verbindung der Kontaktbereiche gesendet wird.

**Revendications**

1. Dans une plaquette à circuit imprimé (34) comportant un circuit (36) imprimé sur une couche en porcelaine (35) portée sur un substrat conducteur de l'électricité, procédé de maîtrise des effets capacitifs se produisant entre le substrat et le circuit, ce procédé étant caractérisé par les étapes consistant à:

— former une zone (39) de dimensions prédéterminées en matériau conducteur de l'électricité sur la couche en porcelaine en plus du circuit imprimé; et

— fournir un moyen (40) pour connecter la zone à la masse, l'agencement étant tel qu'on fournit, en série avec la capacité existant entre le circuit imprimé et le substrat, une capacité entre la zone et le substrat dont la valeur est prédéterminée par les dimensions de ladite zone et l'épaisseur de la couche en porcelaine.

2. Plaquette à circuit imprimé lorsqu'elle est fabriquée selon le procédé de la revendication 1.

3. Ensemble de commutation à boutons-poussoirs pour dispositif de télécommunications comprenant des moyens de bouton-poussoir et un circuit à contacts de commutation associé aux moyens de bouton-poussoir de manière à présenter des zones de contact connectées par le fonctionnement des moyens de bouton-poussoir, caractérisé en ce qu'il comprend une plaquette à circuit (56) selon la revendication 2, le circuit imprimé (62) étant connecté au circuit à contacts de commutation (59) pour transmettre un signal audio à une destination désirée lors de la connexion des zones de contact.

**0 044 138**

Fig 1

Fig 2

Fig 3

Fig 4

Fig 5

1

Fig 7

Fig 6

Fig 8